# EUROPEAN PATENT APPLICATION

(11) **EP 4 752 936 A1**
(43) Date of publication of application: **03.06.2026**
(21) Application number: 25773702.3
(22) Date of filing: 03.03.2025
(51) Int. Cl.: H01L 23/31, H01L 23/29, H01L 23/48, H01L 25/07, H01L 25/18

(54) **SEMICONDUCTOR DEVICE AND METHOD FOR MANUFACTURING SEMICONDUCTOR DEVICE**

(30) Priority: 22.03.2024 JP 2024046524
(71) Applicant: Fuji Electric Co., Ltd., Kawasaki-shi, Kanagawa 210-9530 (JP)
(72) Inventor: NAKAMURA, Tsubasa, Kawasaki-shi, Kanagawa 210-9530 (JP)
(74) Representative: MERH-IP Matias Erny Reichl Hoffmann Patentanwälte PartG mbB
(86) International application number: PCT/JP2025/007408
(87) International publication number: WO 2025/197509

(57) **Abstract**

A distance between a case and a plurality of layers of boards is accurately maintained.

A case of a semiconductor device includes: an armor member (11a) opposed to an upper surface of a wiring board (20) and arranged with a second gap with respect to the upper surface of the wiring board (20); an external connection terminal (12a) fixed to the armor member (11a) and having a lower end inserted into a wiring hole (22a) of the wiring board (20) to be electrically connected to the wiring hole (22a); a first spacer member (14a) protruding from a lower surface of the armor member (11a), inserted through a guide hole (23a) of the wiring board (20), and having a lower end which is in contact with an upper surface of a circuit board (30) to maintain a first distance (L1) between the lower surface of the armor member (11a) and the upper surface of the circuit board (30); and a second spacer member (15a) protruding from the lower surface of the armor member (11a) and having a lower end which is in contact with the upper surface of the wiring board (20) to maintain a second distance (L2) between the lower surface of the armor member (11a) and the upper surface of the wiring board (20).

## Description

### Technical Field

The embodiment discussed herein relates to a semiconductor device and a method for manufacturing semiconductor device.

### Background Art

There has been proposed a semiconductor device including a semiconductor-mounted substrate on which a semiconductor element is mounted and an implant substrate arranged on an upper surface side of the substrate, in which an end portion of an implant pin press-fitted into a via hole formed in the implant substrate is bonded to the semiconductor element to be electrically connected thereto (see, for example, PTL1).

In addition, there has been proposed an in-vehicle semiconductor device including a lower substrate, a positioning plate arranged on an upper layer side of the lower substrate, an upper substrate arranged on an upper layer side of the positioning plate, and a vertical terminal inserted into terminal bored portions formed in both the lower substrate and the upper substrate (see, for example, PTL2).

Furthermore, there has been proposed a semiconductor device including a substrate on which a semiconductor element and first and second terminals are mounted and a case having a terminal holding member surrounding the first and second terminals (see, for example, PTL3).

### Citation List

### Patent Literature

PTL1: Japanese Laid-open Patent Publication No. 2013-125803
PTL2: Japanese Laid-open Patent Publication No. 2010-278093
PTL3: Japanese Laid-open Patent Publication No. 2005-223141

### Summary of Invention

### Technical Problem

An object of the present invention is to provide a semiconductor device and a semiconductor device manufacturing method capable of accurately maintaining a distance between a case and a plurality of layers of boards.

### Solution to Problem

According to one aspect of the invention, there is provided a semiconductor device including: a circuit board; a wiring board opposed to an upper surface of the circuit board, arranged with a first gap with respect to the upper surface of the circuit board, and having a wiring hole and a guide hole penetrating therethrough; a case including an armor member opposed to an upper surface of the wiring board and arranged with a second gap with respect to the upper surface of the wiring board, an external connection terminal fixed to the armor member and having a lower end inserted into the wiring hole of the wiring board to be electrically connected to the wiring hole, a first spacer member protruding from a lower surface of the armor member to be inserted through the guide hole of the wiring board and having a lower end touching the upper surface of the circuit board to maintain a first distance between the lower surface of the armor member and the upper surface of the circuit board, and a second spacer member protruding from the lower surface of the armor member and having a lower end touching the upper surface of the wiring board to maintain a second distance between the lower surface of the armor member and the upper surface of the wiring board; and a sealing member with which the first gap and the second gap are filled to seal the wiring board.

Furthermore, according to another aspect of the invention, there is provided a semiconductor device manufacturing method, including: a preparation step for preparing a circuit board, a wiring board having a wiring hole and a guide hole penetrating therethrough, and a case including an armor member to which an external connection terminal having one end protruding from one main surface is fixed, a first spacer member protruding from the one main surface of the armor member, and a second spacer member protruding from the one main surface of the armor member and having a length from the one main surface shorter than that of the first spacer member; a first setting step for bringing the wiring board closer to the armor member from a side of the one main surface of the armor member in the case, inserting the first spacer member through the guide hole, inserting one end of the external connection terminal into the wiring hole to electrically connect the wiring hole and the external connection terminal, and bringing an end portion of the second spacer member into contact with the wiring board; a second setting step for arranging the circuit board opposite the wiring board on a side of the wiring board opposite to the armor member and bringing the first spacer member inserted through the guide hole of the wiring board into contact with the circuit board; and a sealing step for filling a first gap between the circuit board and the wiring board and a second gap between the wiring board and the armor member with a sealing member to seal the wiring board.

The summary clause does not necessarily describe all necessary features of the embodiment of the present invention. Furthermore, the present invention may also be a subcombination of the features described above.

### Advantageous Effects of Invention

According to the disclosed techniques, the distance between a case and a plurality of layers of boards is accurately maintained.

The foregoing and other objects, features, and advantages of the present disclosure will become apparent from the following description of preferred embodiments, when read together with the accompany drawings.

### Brief Description of Drawings

[FIG. 1] FIG. 1 is a plan view illustrative of the appearance of a semiconductor device.
[FIG. 2] FIG. 2 is a side view illustrative of the appearance of the semiconductor device.
[FIG. 3] FIG. 3 is a plan view of the semiconductor device in a state in which a sealing member and a lid member are removed.
[FIG. 4] FIG. 4 is a side view of the semiconductor device in a state in which the sealing member is removed.
[FIG. 5] FIG. 5 is a plan view of a wiring board.
[FIG. 6] FIG. 6 is a plan view of a circuit board and an external connection terminal.
[FIG. 7] FIG. 7 illustrates an example of the circuit structure of a three-level inverter.
[FIG. 8] FIG. 8 illustrates the positions of spacer members.
[FIG. 9] FIG. 9 is an enlarged sectional view of a fixing region of the spacer members.
[FIG. 10] FIG. 10 is a flowchart illustrative of a process for manufacturing the semiconductor device.
[FIG. 11] FIG. 11 illustrates a step for fixing the wiring board to an armor member.
[FIG. 12] FIG. 12 illustrates the position of a gate port.
[FIG. 13] FIG. 13 is a plan view illustrative of a modification of spacer members.
[FIG. 14] FIG. 14 is an enlarged plan view and an enlarged sectional view of a fixing region of spacer members.

### Description of Embodiment

An embodiment will now be described with reference to the drawings. In the following description, an X axis and a Y axis are defined on a horizontal plane, a Z axis is defined in a direction perpendicular to the horizontal plane, a +Z direction is defined as an upper side, and a -Z direction is defined as a lower side. In addition, "upper surface", "upward", "front surface", "lower surface", "downward", "back surface", and "side surface" are merely expressions for convenience to specify a relative positional relationship, and do not limit the technical idea of the present disclosure. For example, "upward" and "downward" do not always mean a vertical direction with respect to the ground. That is to say, the "upward" and "downward" directions are not limited to the gravity direction.

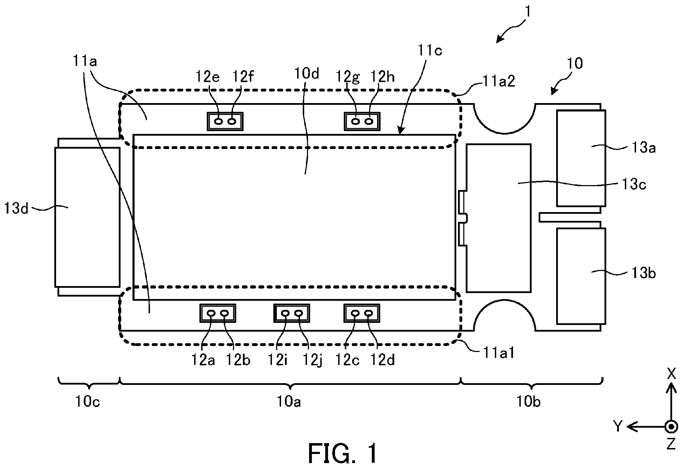

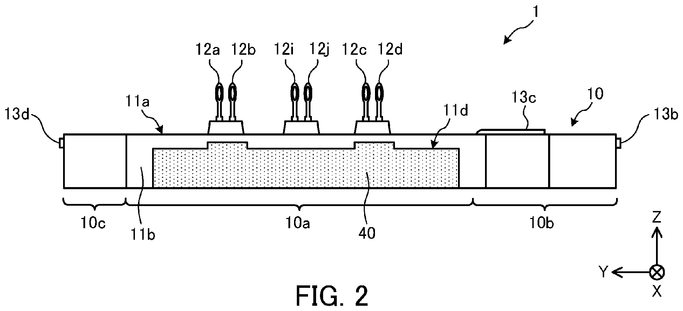

First, the appearance of a semiconductor device according to an embodiment will be described with reference to FIGS. 1 and 2. FIG. 1 is a plan view illustrative of the appearance of the semiconductor device. FIG. 2 is a side view illustrative the appearance of the semiconductor device. FIG. 2 is a side view of the semiconductor device 1 of FIG. 1 when viewed in the +X direction.

The semiconductor device 1 is a device in which a circuit board on which a semiconductor chip is mounted, an external connection terminal, and the like are modularized. The semiconductor device 1 is fixed onto a front surface (surface on the +Z direction side) of a cooling module (not illustrated). The cooling module may be, for example, a heat dissipation base including heat dissipation fins or a cooling device in which coolant circulates.

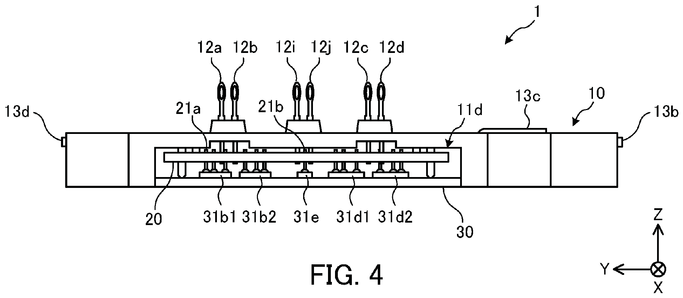

The semiconductor device 1 includes a case 10 which houses a wiring board 20 and a circuit board 30 described later with reference to FIG. 4. The case 10 includes a housing member 10a, terminal holding members 10b and 10c, and a lid member 10d. The terminal holding member 10b is integrally connected to the -Y direction side of the housing member 10a and the terminal holding member 10c is integrally connected to the +Y direction side of the housing member 10a. The lid member 10d is formed in an opening 11c (described later) formed in an armor member 11a. In this case, the lid member 10d may be formed integrally with the armor member 11a to block the opening 11c.

The housing member 10a has, for example, a box shape and includes an armor member 11a forming an upper surface parallel to a horizontal plane (X-Y plane), side walls parallel to a Y-Z plane, and side walls parallel to the X-Y plane. The side walls parallel to the Y-Z plane are formed on the lower side (-Z direction side) of each of end sides in the +X direction and the -X direction of the armor member 11a. In FIG. 2, a side wall 11b on the -X direction side is illustrated and a reference sign of the side wall on the +X direction side is omitted. The side walls (reference signs are omitted) parallel to the X-Y plane are formed on the lower side of each of end sides on the +Y direction side and the -Y direction side of the armor member 11a.

The armor member 11a and the side walls on the +X direction side and the -X direction side may have a flat plate shape and be integrally connected. In addition, the side wall on the +Y direction side may be integrated with an end surface on the -Y direction side of the terminal holding member 10c and the side wall on the -Y direction side may be integrated with an end surface on the +Y direction side of the terminal holding member 10b.

Furthermore, the housing member 10a is not limited to a box shape and may include the exterior member 11a and the side walls parallel to the X-Y plane, which are formed on the lower side of each of the end sides on the +Y direction side and the -Y direction side of the armor member 11a.

The armor member 11a has a rectangular shape in plan view. In addition, the opening 11c having a rectangular shape is formed in a central portion of the armor member 11a in plan view. The opening 11c may be blocked by the lid member 10d formed integrally with the armor member 11a.

The housing member 10a includes a region (housing portion) surrounded by the lower surface of the armor member 11a, the side walls on the +X direction side and the -X direction side, and the side walls on the +Y direction side and the -Y direction side. The above wiring board 20 and circuit board 30 are housed in the housing portion. The armor member 11a forms armor on the upper side of the wiring board 20 and the circuit board 30 housed in the housing portion.

On the other hand, openings for injecting a sealing member 40 are formed on the +X direction side and the -X direction side of the housing portion. In the present embodiment, as an example, side walls are also formed on the +X direction side and the -X direction side of the housing portion and an opening is formed in a part of each side wall. For example, FIG. 2 illustrates the side wall 11b formed on an end side of the armor member 11a on the -X direction side. The side wall 11b has an opening 11d that opens downward (in the -Z direction). The opening 11d is formed between the side wall (terminal holding member 10c) on the +Y direction side and the side wall (terminal holding member 10b) on the -Y direction side of the housing member 10a. The inside of the housing portion is sealed by the sealing member 40 and the opening 11d is blocked from the inside by the sealing member 40. Similarly, the opening 11c of the armor member 11a is blocked from the inside by the sealing member 40. As described above, the sealing member 40 that blocks the opening 11c is further blocked by the lid member 10d.

The armor member 11a includes edge portions 11a1 and 11a2 (first and second regions) extending in the Y-axis direction in side portions of the opening 11c in the -X direction and the +X direction, respectively. External connection terminals 12a to 12d, 12i, and 12j are formed on the edge portion 11a1 of the armor member 11a. Furthermore, external connection terminals 12e to 12h are formed on the edge portion 11a2 of the armor member 11a on the +X direction side. The external connection terminals 12a to 12j have a columnar shape extending in a substantially vertical direction. The columnar shape may be a prismatic shape or a cylindrical shape and, in this case, a cylindrical press-fit pin is exemplified.

The external connection terminals 12a to 12d, 12i, and 12j are fixed to the edge portion 11a1 in a state in which they penetrate the edge portion 11a1 in the vertical direction (±Z direction). The external connection terminals 12e to 12h are fixed to the edge portion 11a2 in a state in which they penetrate the edge portion 11a2 in the vertical direction (±Z direction). Furthermore, upper end portions of the external connection terminals 12a to 12j protruding from the upper surface of the armor member 11a serve as connection terminal portions to be connected to an external circuit. On the other hand, lower end portions of the external connection terminals 12a to 12j protruding from the lower surface of the armor member 11a are inserted into wiring holes formed in the wiring board 20 and are electrically connected to a wiring layer formed on the wiring board 20, as described later.

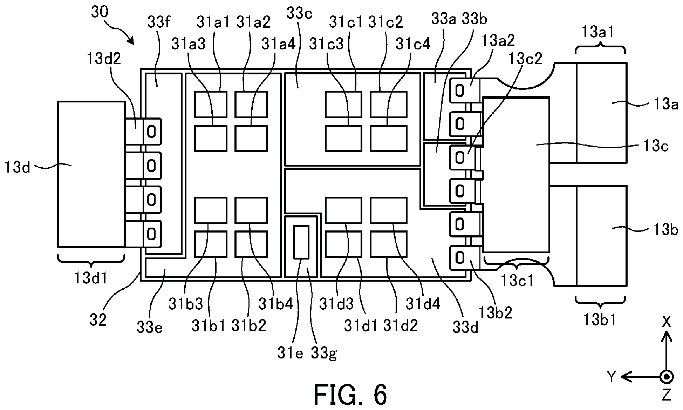

External connection terminals 13a to 13c are formed on the terminal holding member 10b. Flat plate portions 13a1 to 13c1 (see FIG. 6) are formed at end portions (outer end portions) on the -Y direction side of the external connection terminals 13a to 13c, respectively. The external connection terminals 13a to 13c are held by the terminal holding member 10b in a state in which upper surfaces of the flat plate portions 13a1 to 13c1 are exposed to the upper surface of the terminal holding member 10b. In addition, the flat plate portions 13a1 to 13c1 exposed on the upper surface of the terminal holding member 10b serve as connection terminal portions to be connected to an external circuit. On the other hand, end portions (inner end portions) of the external connection terminals 13a to 13c on the +Y direction side are connected to a circuit pattern on the upper surface of the circuit board 30 inside the housing member 10a, as described later.

An external connection terminal 13d is formed on the terminal holding member 10c. A flat plate portion 13d1 (see FIG. 6) is formed at an end portion (outer end portion) of the external connection terminal 13d on the +Y direction side. The external connection terminal 13d is held by the terminal holding member 10c in a state in which an upper surface of the flat plate portion 13d1 is exposed to an upper surface of the terminal holding member 10c. In addition, the flat plate portion 13d1 exposed to the upper surface of the terminal holding member 10c serves as a connection terminal portion to be connected to an external circuit. On the other hand, an end portion (inner end portion) on the -Y direction side of the external connection terminal 13d is connected to a circuit pattern on the upper surface of the circuit board 30 inside the housing member 10a, as described later.

In the present embodiment, a three-level inverter circuit is constituted by the wiring board 20, the circuit board 30, and a semiconductor chip to be described later, which are housed inside the case 10. The external connection terminals 13a to 13d correspond to an N terminal, a P terminal, a neutral terminal, and an output terminal, respectively, of the three-level inverter circuit. The external connection terminals 12a to 12h correspond to control terminals for controlling switching operation of transistors included in the three-level inverter circuit. The external connection terminals 12i and 12j correspond to output terminals that output sense signals from the semiconductor chip that performs various sensing operations.

The case 10 including the housing member 10a and the terminal holding members 10b and 10c includes a part of the external connection terminals 12a to 12j and 13a to 13d and is integrally molded by injection molding using a thermoplastic resin. The lid member 10d may be separately formed by injection molding using the thermoplastic resin. Alternatively, the lid member 10d may be integrally molded in addition to the housing member 10a and the terminal holding members 10b and 10c by injection molding using the thermoplastic resin. The thermoplastic resin is, for example, polyphenylene sulfide resin, polybutylene terephthalate resin, polybutylene succinate resin, polyamide resin, acrylonitrile butadiene styrene resin, or liquid crystal polymer. Furthermore, the external connection terminals 12a to 12j and 13a to 13d are made of metal, such as copper, aluminum, or an alloy containing at least one of them as a main component, having excellent electrical conductivity.

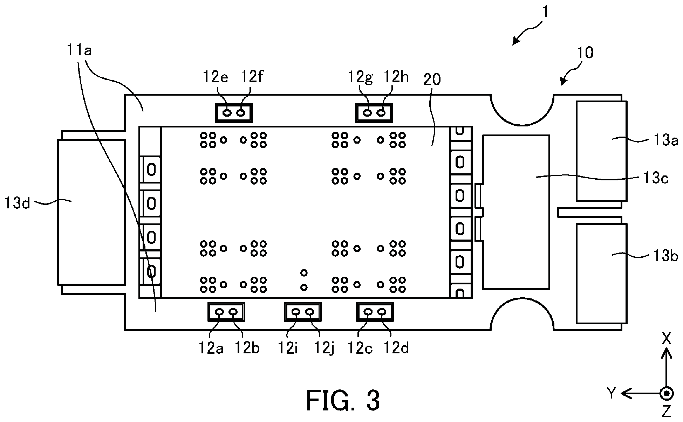

FIG. 3 is a plan view of the semiconductor device in a state in which the sealing member and the lid member are removed. FIG. 4 is a side view of the semiconductor device in a state in which the sealing member is removed.

The wiring board 20 and the circuit board 30 are housed on the lower surface side of the armor member 11a. Each of the wiring board 20 and the circuit board 30 has a rectangular shape in plan view. The wiring board 20 is arranged with a second gap from the lower surface of the armor member 11a in a state in which the upper surface of the wiring board 20 is opposed to the lower surface of the exterior member 11a. In addition, a plurality of wiring holes (described later) penetrate the wiring board 20 and the lower ends of the external connection terminals 12a to 12j are press-fitted into the corresponding wiring holes, so that the wiring board 20 is fixed to the armor member 11a. Furthermore, the external connection terminals 12a to 12j are electrically connected to the wiring layer included in the wiring board 20. The circuit board 30 is arranged with a first gap from the lower surface of the armor member 11a in a state in which the upper surface of the circuit board 30 is opposed to the lower surface of the wiring board 20.

A plurality of semiconductor chips are mounted on the upper surface of the circuit board 30. FIG. 4 illustrates semiconductor chips 31b1, 31b2, 31d1, 31d2, and 31e of these semiconductor chips. On the other hand, a plurality of cylindrical wiring pins extending in the vertical direction are inserted through the wiring board 20. The upper end of each wiring pin is electrically connected to the wiring layer included in the wiring board 20 and the lower end of each wiring pin is electrically connected to an output electrode and a control electrode on the upper surface of a corresponding semiconductor chip via solder. In FIG. 4, for example, wiring pins 21a and 21b are formed on the wiring board 20 and lower ends of the wiring pins 21a and 21b and the upper surfaces of the semiconductor chips 31b1 and 31e are electrically connected via solder. Therefore, the external connection terminals 12a to 12j are electrically connected to output electrodes and control electrodes of the semiconductor chips via the wiring board 20 and the wiring pins.

In addition, in a state in which the wiring board 20 and the circuit board 30 are arranged in the above way with respect to the armor member 11a, at least a region between the lower surface of the armor member 11a and the upper surface of the circuit board 30 is filled with the sealing member 40 and the wiring board 20 and the semiconductor chips are sealed by the sealing member 40. In the present embodiment, the periphery of the circuit board 30 or a side wall of a lower portion of the armor member 11a is not in contact with the terminal holding member 10b or 10c in plan view. Therefore, the region between the lower surface of the armor member 11a and the upper surface of the circuit board 30 is filled with the sealing member 40 so as to cover to side surfaces of the circuit board 30, and the back surface of the circuit board 30 is exposed from the back surface (surface on the -Z direction side) of the housing member 10a (case 10). Furthermore, the back surface of the circuit board 30 may be flush with the back surfaces of the housing member 10a and the terminal holding members 10b and 10c of the case 10.

A thermosetting resin is used as a material for the sealing member 40. The thermosetting resin is, for example, epoxy resin. The semiconductor device 1 having high rigidity is manufactured by performing transfer molding on the case 10 in which the wiring board 20, the circuit board 30, and the semiconductor chip are housed by using the above resin. In particular, high rigidity in the vertical direction (Z-axis direction) of the semiconductor device 1 is obtained. Even when force is applied in the vertical direction from the outside, predetermined distances are maintained between the armor member 11a and the wiring board 20 and between the wiring board 20 and the circuit board 30.

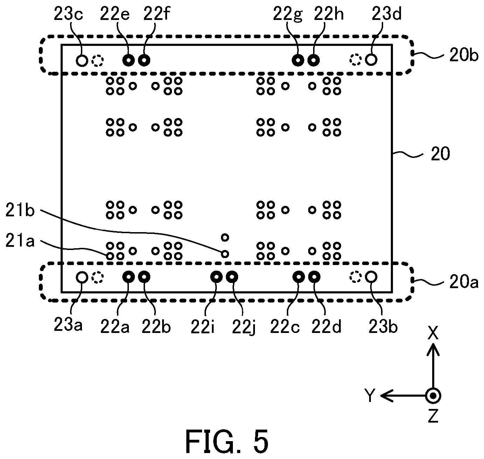

FIG. 5 is a plan view of the wiring board. The wiring board 20 is, for example, a printed circuit board (PCB) having a multilayer structure. In the wiring board 20, for example, a wiring layer may be formed on at least one of an upper surface and a lower surface of an insulating layer, and one or more wiring layers may be formed inside the insulating layer.

The insulating layer is made of, for example, an insulating resin. The insulating resin is, for example, a paper phenol substrate, a paper epoxy substrate, a glass composite substrate, or a glass epoxy substrate. The wiring layer is made of metal, such as copper, aluminum, or an alloy containing at least one of them as a main component, having excellent electrical conductivity.

A plurality of wiring holes (through holes) penetrating the wiring board 20 are formed in the wiring board 20 and wiring pins are inserted into the respective wiring holes. The wiring pin is made of metal having excellent electrical conductivity. Each wiring hole is connected to a circuit pattern of any wiring layer formed on the wiring board 20, and a wiring pin is electrically connected to a circuit pattern connected to the inserted wiring hole. These wiring pins protrude at least to the lower surface side of the corresponding wiring holes. In addition, the wiring pin may also protrude to the upper surface side of the corresponding wiring hole to the extent that the wiring pins do not come into contact with the lower surface of the armor member 11a. In FIG. 5, wiring pins 21a and 21b are illustrated as such wiring pins. As illustrated in FIG. 4, the lower ends of the wiring pins 21a and 21b are electrically connected to the output electrodes and the control electrodes on the upper surfaces of the semiconductor chips 31b1 and 31e mounted on the circuit board 30 via solder.

Furthermore, wiring holes (through holes) 22a to 22j penetrate the wiring board 20. The wiring holes 22a to 22d, 22i, and 22j are arranged along a first edge portion 20a on the -X direction side of the wiring board 20. The region of the first edge portion 20a is a region opposed to a lower surface of an edge portion 11a1 of the armor member 11a when the wiring board 20 is fixed to the armor member 11a. In addition, the lower ends of the external connection terminals 12a to 12d, 12i, and 12j are inserted into the wiring holes 22a to 22d, 22i, and 22j, respectively. Moreover, the wiring holes 22e to 22h are arranged along a second edge portion 20b on the +X direction side of the wiring board 20. The region of the second edge portion 20b is a region opposed to a lower surface of an edge portion 11a2 of the armor member 11a when the wiring board 20 is fixed to the armor member 11a. Furthermore, the lower ends of the external connection terminals 12e to 12h are inserted into the wiring holes 22e to 22h, respectively.

Each of the wiring holes 22a to 22j is also connected to a circuit pattern of any wiring layer formed on the wiring board 20. Furthermore, by inserting the lower ends of the external connection terminals 12a to 12j into the wiring holes 22a to 22j, respectively, the external connection terminals 12a to 12j are electrically connected to the circuit patterns connected to the inserted wiring holes 22a to 22j.

In addition, a via hole for electrically connecting wiring layers may penetrate the wiring board 20.

Furthermore, guide holes 23a to 23d penetrate the wiring board 20. In this case, the guide holes 23a and 23b are arranged along the edge portion 11a1 in a region below the edge portion 11a1 of the armor member 11a in plan view when the wiring board 20 is fixed to the armor member 11a. In addition, the guide holes 23c and 23d are arranged along the edge portion 11a2 in a region below the edge portion 11a2 of the armor member 11a in plan view when the wiring board 20 is fixed to the armor member 11a. The details of the guide holes 23a to 23d will be described later.

FIG. 6 is a plan view of the circuit board and the external connection terminals.

The circuit board 30 includes an insulating plate 32 forming a bottom surface, circuit patterns 33a to 33g formed on an upper surface (surface on the +Z direction side) of the insulating plate 32, and a metal plate (not illustrated) formed on a lower surface (surface on the -Z direction side) of the insulating plate 32. Furthermore, semiconductor chips 31a1 to 31a4, 31b1 to 31b4, 31c1 to 31c4, 31d1 to 31d4, and 31e are mounted on the circuit board 30.

The insulating plate 32 is made of, for example, resin. The resin may be a material having low thermal resistance and a high insulating property, and may be a thermosetting resin or a thermoplastic resin. The thermosetting resin is, for example, at least one of epoxy resin, cyanate resin, polyimide resin, benzoxazine resin, unsaturated polyester resin, phenol resin, melamine resin, silicone resin, and maleimide resin. The thermoplastic resin is, for example, at least one of acrylic resin and polyamide resin. These resins may further contain a filler. The filler is made of at least one of an oxide and a nitride. The oxide is, for example, silicon oxide or aluminum oxide. The nitride is, for example, silicon nitride, aluminum nitride, or boron nitride. Furthermore, hexagonal boron nitride may be used as the filler.

The insulating plate 32 may be a ceramic board instead of resin. The ceramic board is made of a ceramic having good thermal conductivity. The ceramic is made of, for example, a material containing aluminum oxide, aluminum nitride, or silicon nitride as a main component. For example, a direct copper bonding (DCB) substrate or an active metal brazed (AMB) substrate is used as the insulating circuit board 30 including the insulating plate 32 having the above structure.

In the present embodiment, the insulating plate 32 is made of resin and the difference in linear expansion coefficient between the insulating plate 32 and the metal plate and the circuit patterns 33a to 33g is small.

The circuit patterns 33a to 33f and the metal plate are made of metal, such as copper, aluminum, or an alloy containing at least one of them as a main component, having excellent electrical conductivity.

The semiconductor chips 31a1 to 31a4, 31b1 to 31b4, 31c1 to 31c4, and 31d1 to 31d4 may be power metal-oxide-semiconductor field-effect transistors (MOSFETs) containing silicon carbide as a main component. In the power MOSFET, a body diode may function as a free wheeling diode (FWD). Each of the semiconductor chips 31a1 to 31a4, 31b1 to 31b4, 31c1 to 31c4, and 31d1 to 31d4 includes, for example, an input electrode (drain electrode) as a main electrode on the back surface, and includes an output electrode (source electrode) as a main electrode and a control electrode (gate electrode) on the front surface.

Alternatively, each of the semiconductor chips 31a1 to 31a4, 31b1 to 31b4, 31c1 to 31c4, and 31d1 to 31d4 may include a switching element containing silicon as a main component. The switching element may be, for example, a reverse-conducting insulated gate bipolar transistor (RC-IGBT). The RC-IGBT is a semiconductor element in which an IGBT and an FWD are connected in inverse parallel in one chip. Each of these semiconductor chips 31a1 to 31a4, 31b1 to 31b4, 31c1 to 31c4, and 31d1 to 31d4 includes, for example, an input electrode (collector electrode) as a main electrode on the back surface, and includes an output electrode (emitter electrode) as a main electrode and a control electrode (gate electrode) on the front surface.

Furthermore, each of the semiconductor chips 31a1 to 31a4, 31b1 to 31b4, 31c1 to 31c4, and 31d1 to 31d4 may be a semiconductor chip including a set of a switching element and a diode element containing silicon as a main component. The switching element is, for example, a power MOSFET or an IGBT. A semiconductor chip including a switching element includes, for example, an input electrode (drain electrode in a power MOSFET or a collector electrode in an IGBT) as a main electrode on the back surface, and includes a gate electrode as a control electrode and an output electrode (source electrode in a power MOSFET or an emitter electrode in an IGBT) as a main electrode on the front surface. Furthermore, As the diode element, for example, a Schottky barrier diode (SBD) or a P-intrinsic-N (PiN) diode is used as the FWD. A semiconductor chip including a diode element includes, for example, an output electrode (cathode electrode) as a main electrode on the back surface and includes an input electrode (anode electrode) as a main electrode on the front surface.

In the present embodiment, the semiconductor chips 31a1 to 31a4, 31b1 to 31b4, 31c1 to 31c4, and 31d1 to 31d4 are power MOSFETs containing silicon carbide as a main component.

The semiconductor chips 31c1 to 31c4 are mounted on the upper surface of the circuit pattern 33c. Although not illustrated, the input electrodes on the lower surfaces of the semiconductor chips 31c1 to 31c4 are electrically connected to the upper surface of the circuit pattern 33c via solder. The semiconductor chips 31d1 to 31d4 are mounted on the upper surface of the circuit pattern 33d. Although not illustrated, the input electrodes on the lower surfaces of the semiconductor chips 31d1 to 31d4 are electrically connected to the upper surface of the circuit pattern 33d via solder. The semiconductor chips 31a1 to 31a4 and 31b1 to 31b4 are mounted on the upper surface of the circuit pattern 33e. Although not illustrated, the input electrodes on the lower surfaces of the semiconductor chips 31a1 to 31a4 and 31b1 to 31b4 are electrically connected to the upper surface of the circuit pattern 33e via solder.

The semiconductor chip 31e is mounted on the upper surface of the circuit pattern 33g. The semiconductor chip 31e includes semiconductor elements that perform various sensing operations. For example, the semiconductor chip 31e includes a diode element that detects temperature. Although not illustrated, an electrode formed on the lower surface of the semiconductor chip 31e is electrically connected to the upper surface of the circuit pattern 33g via solder.

The circuit pattern 33a is electrically connected to the external connection terminal 13a. Specifically, the flat plate portion 13a1 is formed on an end portion of the external connection terminal 13a on the -Y direction side. Furthermore, on an end portion of the flat plate portion 13a1 of the external connection terminal 13a on the +Y direction side, a connection portion 13a2 having a flat plate shape is formed in the horizontal direction via an intermediate portion (not illustrated) extending in the downward direction (-Z direction). In addition, the lower surface of the connection portion 13a2 is bonded to the upper surface of the circuit pattern 33a.

The circuit pattern 33b is electrically connected to the external connection terminal 13c. Specifically, the flat plate portion 13c1 is formed on an end portion of the external connection terminal 13c on the -Y direction side. In addition, a connection portion 13c2 having a flat plate shape is formed in the horizontal direction on an end portion of the flat plate portion 13c1 of the external connection terminal 13c on the +Y direction side via an intermediate portion (not illustrated) extending in the downward direction (-Z direction). Furthermore, the lower surface of the connection portion 13c2 is bonded to the upper surface of the circuit pattern 33b.

The circuit pattern 33d is electrically connected to the external connection terminal 13b. Specifically, a flat plate portion 13b1 is formed on an end portion of the external connection terminal 13b on the -Y direction side. In addition, a connection portion 13b2 having a flat plate shape is formed in the horizontal direction on an end portion on the +Y direction side of the flat plate portion 13b1 of the external connection terminal 13b via an intermediate portion (not illustrated) extending in the downward direction (-Z direction). Furthermore, the lower surface of the connection portion 13b2 is bonded to the upper surface of the circuit pattern 33d.

The circuit pattern 33f is electrically connected to the external connection terminal 13d. Specifically, the flat plate portion 13d1 is formed on an end portion of the external connection terminal 13d on the +Y direction side. In addition, a connection portion 13d2 having a flat plate shape is formed in the horizontal direction on an end portion on the -Y direction side of the flat plate portion 13d1 of the external connection terminal 13d via an intermediate portion (not illustrated) extending in the downward direction (-Z direction). Furthermore, the lower surface of the connection portion 13d2 is bonded to the upper surface of the circuit pattern 33f.

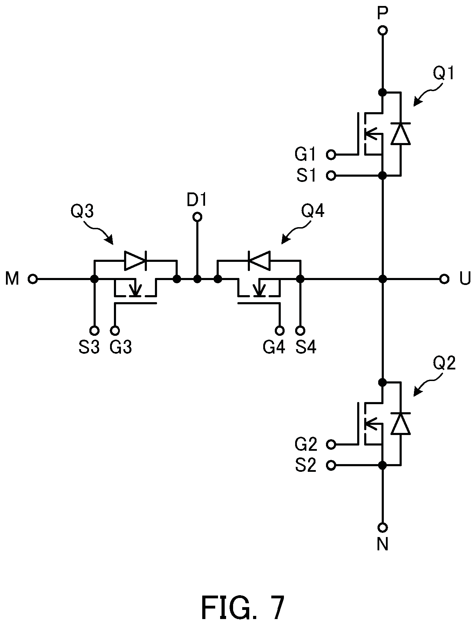

FIG. 7 illustrates an example of the circuit structure of a three-level inverter. The semiconductor device 1 includes, for example, the three-level inverter illustrated in FIG. 7. The three-level inverter is a T-type neutral point clamped (NPC) inverter circuit and includes four transistors Q1 to Q4. The transistor Q1 corresponds to the semiconductor chips 31d1 to 31d4 and the transistor Q2 corresponds to the semiconductor chips 31c1 to 31c4. Furthermore, the transistor Q3 corresponds to the semiconductor chips 31b1 to 31b4 and the transistor Q4 corresponds to the semiconductor chips 31a1 to 31a4.

A drain electrode of the transistor Q1 is connected to a P terminal, which is an input terminal on a positive electrode side, via the circuit board 30. The P terminal corresponds to the external connection terminal 13b. A source electrode of the transistor Q2 is connected to an N terminal, which is an input terminal on a negative electrode side, via the wiring board 20 and the circuit board 30. The N terminal corresponds to the external connection terminal 13a.

A drain electrode of the transistor Q3 and a drain electrode of the transistor Q4 are connected to each other via the circuit board 30 and a source electrode of the transistor Q3 is connected to an M terminal (neutral terminal) which is an input terminal at an intermediate potential via the wiring board 20 and the circuit board 30. The M terminal corresponds to the external connection terminal 13c.

A source electrode of the transistor Q1, a drain electrode of the transistor Q2, and a source electrode of the transistor Q4 are connected to one another via the circuit board 30 and the wiring board 20, and a connection point of them is connected to a U terminal, which is an output terminal, via the wiring board 20 and the circuit board 30. The U terminal corresponds to the external connection terminal 13d.

Gate electrodes of the transistors Q1 to Q4 are connected to gate terminals (control terminals) G1 to G4, respectively, which are input terminals of control signals for switching operations, via the wiring board 20. The gate terminals G1 to G4 correspond to the external connection terminals 12c, 12g, 12b, and 12f, respectively. The source electrodes of the transistors Q1 to Q4 are connected to auxiliary source terminals S1 to S4, respectively, which are output terminals, via the wiring board 20. The auxiliary source terminals S1 to S4 correspond to the external connection terminals 12d, 12h, 12a, and 12e, respectively.

In this three-level inverter, when control signals to the gate terminals G1 and G2 are on and control signals to the gate terminals G3 and G4 are off, an output voltage from the U terminal is E/2. When control terminals connected to the gate terminals G2 and G3 are on and the control terminals connected to the gate terminals G1 and G4 are off, an output voltage from the U terminal is 0. When control signals to the gate terminals G3 and G4 are on and control signals to the gate terminals G1 and G2 are off, an output voltage from the U terminal is -E/2.

The semiconductor device 1 according to the present embodiment includes four sets of transistors Q1 to Q4. Therefore, the semiconductor device 1 includes four sets of three-level inverters each including the transistors Q1 to Q4. These three-level inverters are connected in parallel. Although not illustrated, three semiconductor devices 1 each including four three-level inverters connected in parallel are used in combination. One semiconductor device 1 generates a U-phase output voltage, another semiconductor device 1 generates a V-phase output voltage, and still another semiconductor device 1 generates a W-phase output voltage.

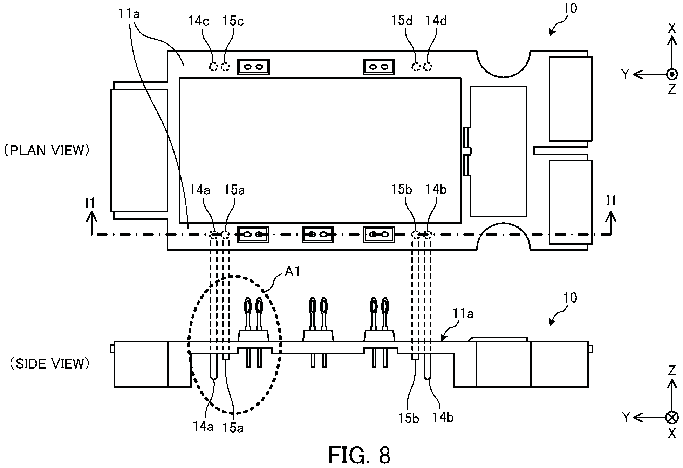

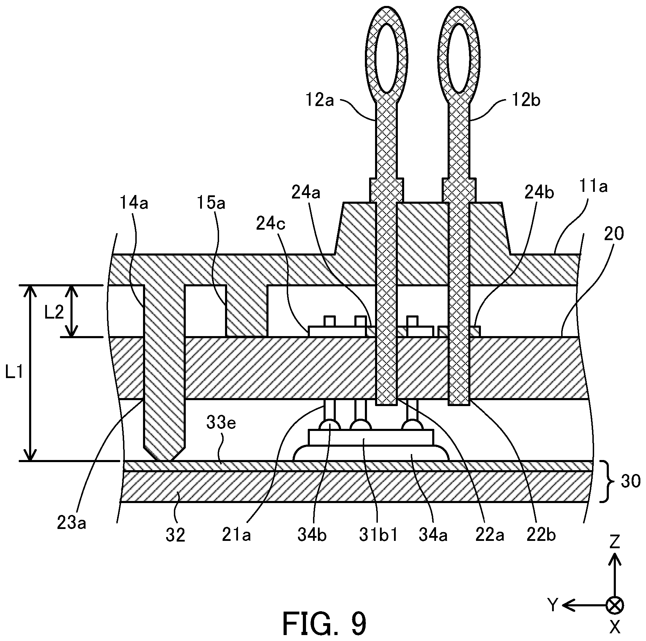

Spacer members for positioning the wiring board 20 and the circuit board 30 with respect to the armor member 11a of the case 10 will now be described with reference to FIGS. 8 and 9.

FIG. 8 illustrates the positions of spacer members. First spacer members 14a to 14d and second spacer members 15a to 15d are formed on the lower surface of the armor member 11a of the case 10. The first spacer members 14a and 14b and the second spacer members 15a and 15b protrude from the lower surface of the edge portion 11a1 (see FIG. 1) of the armor member 11a. The first spacer members 14c and 14d and the second spacer members 15c and 15d protrude from the lower surface of the edge portion 11a2 (see FIG. 1) of the armor member 11a.

The first spacer members 14a to 14d and the second spacer members 15a to 15d have a columnar shape. In the present embodiment, as an example, the first spacer members 14a to 14d and the second spacer members 15a to 15d have a cylindrical shape, but may have, for example, a prismatic shape. The first spacer members 14a to 14d have the same length (L1) in the vertical direction. The second spacer members 15a to 15d have the same length (L2) in the vertical direction and are shorter than the first spacer members 14a to 14d.

In a state in which the wiring board 20 is fixed to the armor member 11a, the lower ends of the second spacer members 15a to 15d are in contact with the upper surface of the wiring board 20. Therefore, the distance between the lower surface of the armor member 11a and the upper surface of the wiring board 20 is maintained at the predetermined second distance L2. Furthermore, in this state, the first spacer members 14a to 14d are inserted through the guide holes 23a to 23d (see FIG. 5), respectively, formed in the wiring board 20, and the lower ends of the first spacer members 14a to 14d are in contact with the upper surface of the circuit board 30. Therefore, the distance between the lower surface of the armor member 11a and the upper surface of the circuit board 30 is maintained at the predetermined first distance L1. As a result, the distance between the lower surface of the wiring board 20 and the upper surface of the circuit board 30 is also maintained at a predetermined distance. At the same time, the first spacer members 14a to 14d are inserted through the guide holes 23a to 23d, respectively. Therefore, the wiring board 20 is positioned in the horizontal direction with respect to the armor member 11a.

FIG. 9 is an enlarged sectional view of a fixing region of the spacer members. FIG. 9 is an enlarged sectional view of a region A1 of FIG. 8 taken along the line I1-I1. However, it is assumed that the wiring board 20 and the circuit board 30 are fixed in the case 10 as illustrated in FIGS. 3 and 4.

In the region A1, the external connection terminals 12a and 12b are fixed to the edge portion 11a1 in a state in which the external connection terminals 12a and 12b penetrate the edge portion 11a1 of the armor member 11a in the vertical direction. Furthermore, the lower ends of the external connection terminals 12a and 12b are inserted into the wiring holes 22a and 22b, respectively, formed in the wiring board 20. For example, circuit patterns 24a and 24b are formed on the upper surface of the wiring board 20 at positions surrounding the wiring holes 22a and 22b, respectively. The lower ends of the external connection terminals 12a and 12b are inserted into the wiring holes 22a and 22b, respectively, so that the external connection terminals 12a and 12b are electrically connected to the circuit patterns 24a and 24b, respectively. In addition, the lower ends of the external connection terminals 12a and 12b are press-fitted into the wiring holes 22a and 22b, respectively, so that the wiring board 20 is fixed to the edge portion 11a1 of the armor member 11a.

Furthermore, in the region A1, the first spacer member 14a and the second spacer member 15a protrude from the lower surface of the edge portion 11a1 of the armor member 11a. The lower end of the second spacer member 15a is in contact with the upper surface of the wiring board 20. As a result, the distance between the lower surface of the edge portion 11a1 and the upper surface of the wiring board 20 is maintained at the second distance L2 which is the length of the second spacer member 15a in the vertical direction.

The second distance L2 is set in advance so that the lower ends of the external connection terminals 12a and 12b reach the lower ends of the wiring holes 22a and 22b or a predetermined position beyond the lower ends. By doing so, when the external connection terminals 12a and 12b fixed to the armor member 11a are press-fitted into the wiring holes 22a and 22b, respectively, of the wiring board 20, the distance between the lower surface of the edge portion 11a1 of the armor member 11a and the upper surface of the wiring board 20 is set to the predetermined second distance L2 only by press-fitting the external connection terminals 12a and 12b until the tip of the second spacer member 15a comes into contact with the upper surface of the wiring board 20. Therefore, high positioning accuracy in the vertical direction is obtained by an easy manufacturing process and assembly workability of the semiconductor device 1 is improved.

Furthermore, the first spacer member 14a is inserted through the guide hole 23a formed in the wiring board 20 and the lower end of the first spacer member 14a is in contact with the upper surface of the circuit board 30. Therefore, the distance between the lower surface of the edge portion 11a1 and the upper surface of the circuit board 30 is maintained at the first distance L1, which is the length of the first spacer member 14a in the vertical direction. As a result, a gap between the lower surface of the wiring board 20 and the upper surface of the circuit board 30 is maintained at a desired gap.

As illustrated in FIG. 9, the wiring pin 21a is inserted through the wiring board 20 and the wiring pin 21a is electrically connected to, for example, a circuit pattern 24c formed on the upper surface of the wiring board 20. On the other hand, the circuit pattern 33e is formed on the upper surface of the insulating plate 32 of the circuit board 30 and the semiconductor chip 31b1 is mounted on the upper surface of the circuit pattern 33e via solder 34a. In addition, the lower end of the wiring pin 21a is bonded to the upper surface of the semiconductor chip 31b1 via solder 34b.

As described above, a gap is needed between the lower surface of the wiring board 20 and the upper surface of the circuit board 30 for bonding the wiring pins and the semiconductor chip via solder. As described above, the lower ends of the first spacer member 14a and the second spacer member 15a come into contact with the upper surface of the circuit board 30 and the upper surface of the wiring board 20, respectively. Therefore, it is possible to easily maintain a desired gap between the lower surface of the wiring board 20 and the upper surface of the circuit board 30.

Furthermore, because the first spacer member 14a is inserted through the guide hole 23a, it is possible to accurately position the wiring board 20 in the horizontal direction with respect to the armor member 11a by a simple operation. In particular, as described above, when the wiring board 20 is fixed, the external connection terminals 12a and 12b are inserted into the wiring holes 22a and 22b, respectively, of the wiring board 20. At this time, since the first spacer member 14a is inserted first into the guide hole 23a of the wiring board 20, the positions of the end portions of the external connection terminals 12a and 12b are easily aligned with the positions of the wiring holes 22a and 22b, respectively.

As illustrated in FIG. 9, the lower end portion of the first spacer member 14a (tip portion that comes into contact with the wiring board 20) has a shape in which the cross-sectional area is reduced in a tapered shape toward the lower end. This facilitates insertion of the first spacer member 14a into the guide hole 23a. For example, even if the center of the diameter of the first spacer member 14a does not accurately coincide with the center of the diameter of the guide hole 23a in plan view, the first spacer member 14a is able to be inserted into the guide hole 23a. Therefore, it is possible to improve workability when the wiring board 20 is fixed to the armor member 11a. The lower ends of the other first spacer members 14b to 14d have the same shape as that of the first spacer member 14a.

Furthermore, among the first spacer members 14a to 14d and the second spacer members 15a to 15d, a pair of a first spacer member and a second spacer member adjacent to each other (spacer member pair) may be described as follows. In order to stably maintain the distance between the lower surface of the armor member 11a and the upper surface of the wiring board 20 at a constant distance over the entire surface where the lower surface of the armor member 11a and the upper surface of the wiring board 20 are opposed to each other, for example, it is desirable that two or more pairs of spacer members be arranged on one edge portion (for example, the edge portion 11a1) of the armor member 11a and one or more pairs of spacer members be arranged on the other edge portion opposite the one edge portion. At this time, it is desirable that the pairs of spacer members are arranged at positions near both end portions in the Y-axis direction on the one edge portion and the pairs of spacer members be arranged at positions near a central portion in the Y-axis direction on the other edge portion.

In addition, if four or more pairs of spacer member are arranged, it is desirable that the pairs of spacer members be arranged at positions near one end and the other end of the one edge portion in the Y-axis direction and the pairs of spacer members be arranged at positions near one end and the other end of the other edge portion in the Y-axis direction (that is, the pairs of spacer members be arranged at positions near the four corners of the armor member 11a having a rectangular shape in plan view).

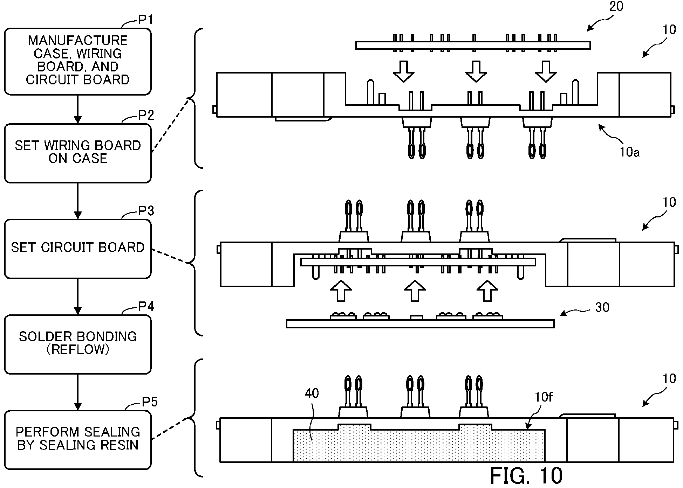

A process for manufacturing the semiconductor device 1 will now be described with reference to FIGS. 10 to 12.

FIG. 10 is a flowchart illustrative of a process for manufacturing the semiconductor device.

[Step P1] The case 10, the wiring board 20, and the circuit board 30 are manufactured. When the case 10 is manufactured, for example, a predetermined metal mold in which the external connection terminals 12a to 12j and 13a to 13d are set is filled with resin. After that, the metal mold is removed and the case 10 including the external connection terminals 12a to 12j and 13a to 13d, in which the housing member 10a, the terminal holding members 10b and 10c, and the lid member 10d are integrally molded, is manufactured. Furthermore, at this time, the first spacer members 14a to 14d and the second spacer members 15a to 15d are formed on the armor member 11a of the case 10.

With the wiring board 20, the circuit patterns are formed, the wiring holes 22a to 22j and the guide holes 23a to 23d penetrate, and the wiring pins are fixed. The circuit patterns are formed on the circuit board 30 and the semiconductor chips 31a1 to 31a4, 31b1 to 31b4, 31c1 to 31c4, 31d1 to 31d4, and 31e are bonded to the circuit board 30 via solder. In this case, a sintered metal material may be used instead of the solder.

[Step P2] The wiring board 20 is set on the case 10. In this step, the wiring board 20 is fixed to the back surface (surface in the direction in which the first spacer members and the second spacer members protrude) of the armor member 11a of the case 10 in a state in which the case 10 and the wiring board 20 are vertically inverted. First, the wiring board 20 is brought near the back surface of the armor member 11a and the first spacer members 14a to 14d are inserted into the guide holes 23a to 23d, respectively, of the wiring board 20. Furthermore, the first spacer members 14a to 14d pass through the guide holes 23a to 23d, respectively, and the end portions of the external connection terminals 12a to 12j are inserted into the wiring holes 22a to 22j, respectively, of the wiring board 20. When the wiring board 20 is pressed against the armor member 11a, the external connection terminals 12a to 12j are press-fitted into the wiring holes 22a to 22j, respectively. Such press-fitting is performed until the end portions of the second spacer members 15a to 15d come into contact with the wiring board 20.

[Step P3] The circuit board 30 is set on the case 10 to which the wiring board 20 is fixed. In this step, the vertical direction of the case 10 is changed so that the main surface of the case 10 (surface on which the external connection terminals 13a to 13d are exposed) faces upward. Furthermore, with the circuit board 30, solder is applied to the electrodes on the upper surfaces of the semiconductor chips 31a1 to 31a4, 31b1 to 31b4, 31c1 to 31c4, 31d1 to 31d4, and 31e for bonding to the corresponding wiring pins. Furthermore, the circuit board 30 is brought near from the lower surface side of the armor member 11a and the circuit board 30 is arranged at a position where the end portions of the first spacer members 14a to 14d come into contact with the upper surface of the circuit board 30.

In a state in which the end portions of the second spacer members 15a to 15d are in contact with the wiring board 20 in step P2 and the end portions of the first spacer members 14a to 14d are in contact with the circuit board 30 in step P3, a desired gap is formed between the lower surface of the armor member 11a and the upper surface of the wiring board 20 and between the lower surface of the wiring board 20 and the upper surface of the circuit board 30. The above distances are maintained in this way by the lengths of the first spacer members 14a to 14d and the second spacer members 15a to 15d in the vertical direction. As a result, it is possible to improve the workability of fixing the wiring board 20 and the circuit board 30 to the case 10.

[Step P4] Reflow is performed. The case 10 on which the wiring board 20 and the circuit board 30 are set in step P3 is heated, and the solder is melted. After the solder is melted, cooling is performed to solidify the solder, and the electrodes on the upper surfaces of the semiconductor chips 31a1 to 31a4, 31b1 to 31b4, 31c1 to 31c4, 31d1 to 31d4, and 31e are bonded to the corresponding wiring pins via the solder.

[Step P5] The case 10 is set in a cavity of a predetermined molding device. In the molding device, a molten sealing raw material in a pod is pressurized by a plunger and is fed from the pod to a runner. The sealing member is injected from a gate into a gate port, which will be described later, of an opening (including the opening 11d) in a side portion of the housing member 10a in the X-axis direction. The sealing raw material injected into the case 10 is cured and the wiring board 20, the circuit board 30, and the semiconductor chips 31a1 to 31a4, 31b1 to 31b4, 31c1 to 31c4, 31d1 to 31d4, and 31e are sealed by the sealing member 40. The semiconductor device 1 illustrated in FIGS. 1 and 2 is obtained by performing this transfer molding on the case 10.

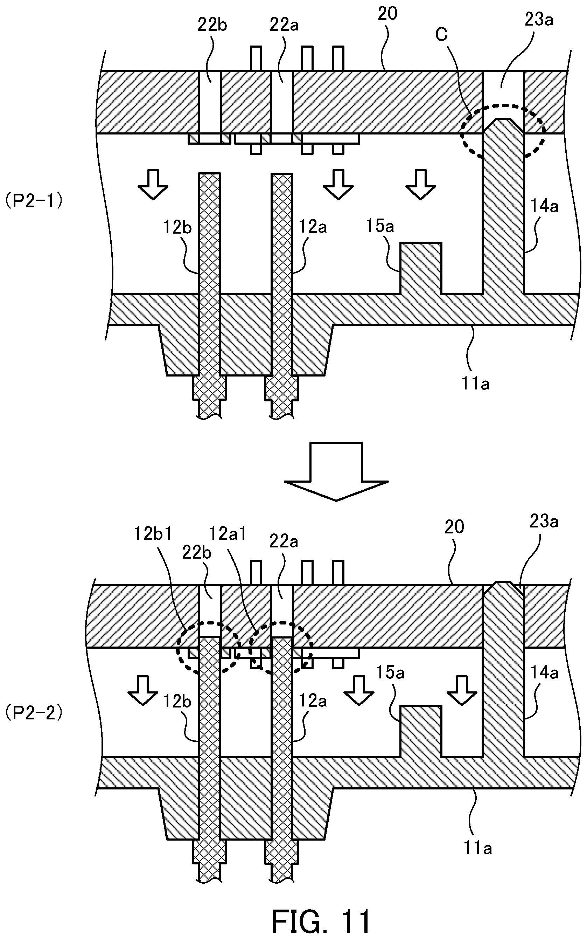

FIG. 11 illustrates a step for fixing the wiring board to the armor member. FIG. 11 is an enlarged sectional view of the region A1 of FIG. 8 taken along the line I1-I1 in the step P2 of FIG. 10.

As described above, in step P2, the case 10 and the wiring board 20 are turned upside down. In this state, the wiring board 20 is brought near the back surface (surface in the direction in which the first spacer member 14a and the second spacer member 15a protrude) of the armor member 11a of the case 10. At this time, the amount of protrusion of the first spacer member 14a from the back surface of the armor member 11a is larger than the amount of protrusion of the external connection terminals 12a and 12b. Therefore, before the end portions of the external connection terminals 12a and 12b are inserted into the wiring holes 22a and 22b, respectively, of the wiring board 20, the end portion of the first spacer member 14a is inserted into the guide hole 23a of the wiring board 20 (step P2-1).

As described above, the tip portion of the first spacer member 14a (in contact with the wiring board 20) has a shape in which the cross-sectional area is reduced in a tapered shape toward the end portion. Therefore, in step P2-1, the first spacer member 14a is easily inserted into the guide hole 23a. For example, even if the center of the diameter of the first spacer member 14a does not accurately coincide with the center of the diameter of the guide hole 23a in plan view, the first spacer member 14a is able to be inserted into the guide hole 23a. Therefore, the workability of positioning the first spacer member 14a with respect to the guide hole 23a is improved.

When the wiring board 20 is further brought near the armor member 11a, the end portions 12a1 and 12b1 of the external connection terminals 12a and 12b are inserted into the wiring holes 22a and 22b, respectively, of the wiring board 20 (step P2-2). At this time, because the first spacer member 14a is inserted into the guide hole 23a, the wiring board 20 is positioned in the horizontal direction with respect to the armor member 11a. Therefore, the end portions 12a1 and 12b1 of the external connection terminals 12a and 12b are smoothly inserted into the wiring holes 22a and 22b, respectively.

In particular, because the external connection terminals 12a and 12b are press-fitted into the wiring holes 22a and 22b, respectively, high accuracy is needed for positioning the end portions 12a1 and 12b1 of the external connection terminals 12a and 12b with respect to the wiring holes 22a and 22b. By inserting the first spacer member 14a into the guide hole 23a as described above, the accuracy of this positioning is improved and the workability of press-fitting is improved. In addition, it is possible to reduce the possibility that components are damaged by press-fitting the external connection terminals 12a and 12b in a state in which the positions of the external connection terminals 12a and 12b with respect to the wiring holes 22a and 22b are shifted.

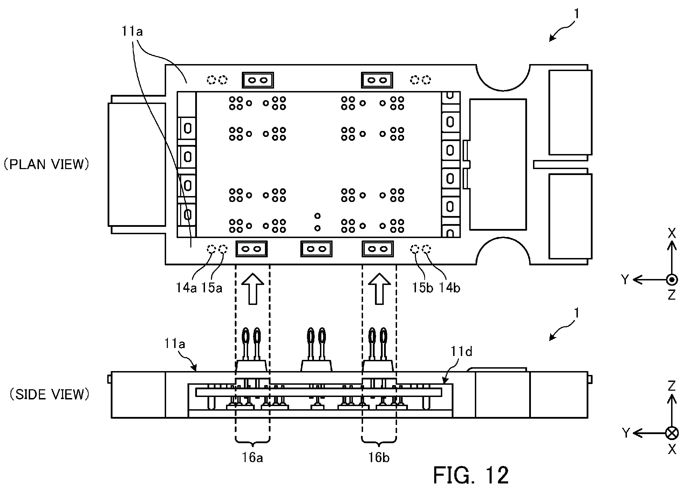

FIG. 12 illustrates the position of a gate port. In FIG. 12, a plan view and a side view of the semiconductor device 1 in a state in which the sealing member 40 and the lid member 10d are removed are given.

As described above, openings are formed in the side wall of the housing member 10a in the X-axis direction. For example, an opening 11d is formed in the side wall 11b on the -X direction side. In step P5 of FIG. 10, the sealing member 40 is injected from these openings to seal the inside of the case 10.

As illustrated in FIG. 12, in the present embodiment, as an example, only partial regions of the opening 11d are enlarged in the upward direction (+Z direction) and the enlarged regions constitute gate ports 16a and 16b for injecting the sealing raw material of the sealing member 40 in step P5 of FIG. 10. In the example of FIG. 12, the sealing raw material of the sealing member 40 is injected into the gate ports 16a and 16b in the +X direction.

It is desirable that the first spacer members 14a and 14b and the second spacer members 15a and 15b formed on the edge portion 11a1 of the armor member 11a be formed at positions shifted from the gate ports 16a and 16b in a direction (Y-axis direction) along the edge portion 11a1. This prevents the spacer members from inhibiting the inflow of the sealing raw material of the sealing member 40 from the gate ports 16a and 16b. By shifting the positions of the first spacer members 14a and 14b from the gate ports 16a and 16b, the inside of the case 10 is properly filled with the sealing member 40, a deterioration in the insulating property is suppressed, and a deterioration in the reliability of the semiconductor device 1 is prevented.

A modification in which the shapes of the first spacer members and the second spacer members are changed will now be described. In the above embodiment, the first spacer members and the second spacer members are formed as separate columnar members. In contrast, first spacer members and second spacer members may be formed as integrated members.

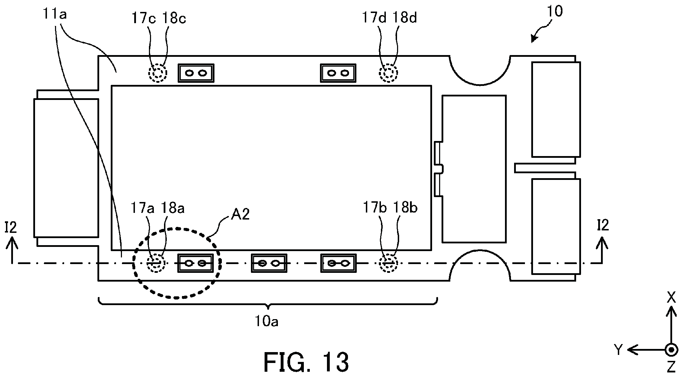

FIG. 13 is a plan view illustrative of a modification of spacer members. FIG. 13 is a plan view of the case 10 in which a modification of spacer members is formed.

In the example of FIG. 13, first spacer members 17a to 17d and second spacer members 18a to 18d are formed near the four corners of the armor member 11a in plan view on the lower surface of the armor member 11a of the case 10. That is to say, the first spacer members 17a and 17b and the second spacer members 18a and 18b are formed on the lower surface of the edge portion 11a1 (see FIG. 1) of the armor member 11a and the first spacer members 17c and 17d and the second spacer members 18c and 18d are formed on the lower surface of the edge portion 11a2 (see FIG. 1) of the armor member 11a.

Furthermore, the first spacer member 17a and the second spacer member 18a are formed as an integral member. The second spacer member 18a is a columnar member protruding from the lower surface (surface on the -Z direction side) of the armor member 11a. The length in the vertical direction of the second spacer member 18a is L2 (see FIG. 9). The first spacer member 17a is a columnar member having the same central axis as that of the second spacer member 18a and having a cross-sectional area smaller than that of the second spacer member 18a and is formed to protrude from the lower end of the second spacer member 18a. The length from the lower surface of the armor member 11a to the lower end of the first spacer member 17a is L1 (see FIG. 9).

Similarly, the first spacer member 17b and the second spacer member 18b are formed as an integral member. The second spacer member 18b is a columnar member protruding from the lower surface of the armor member 11a, and the length in the vertical direction of the second spacer member 18b is L2. The first spacer member 17b is a columnar member having the same central axis as that of the second spacer member 18b and having a cross-sectional area smaller than that of the second spacer member 18b, and is formed to protrude from the lower end of the second spacer member 18b. The length from the lower surface of the armor member 11a to the lower end of the first spacer member 17b is L1.

Furthermore, the first spacer member 17c and the second spacer member 18c are formed as an integral member. The second spacer member 18c is a columnar member protruding from the lower surface of the armor member 11a, and the length in the vertical direction of the second spacer member 18c is L2. The first spacer member 17c is a columnar member having the same central axis as that of the second spacer member 18c and having a cross-sectional area smaller than that of the second spacer member 18c, and is formed to protrude from the lower end of the second spacer member 18c. The length from the lower surface of the armor member 11a to the lower end of the first spacer member 17c is L1.

In addition, the first spacer member 17d and the second spacer member 18d are formed as an integral member. The second spacer member 18d is a columnar member protruding from the lower surface of the armor member 11a, and the length in the vertical direction of the second spacer member 18d is L2. The first spacer member 17d is a columnar member having the same central axis as that of the second spacer member 18d and having a cross-sectional area smaller than that of the second spacer member 18d, and is formed to protrude from the lower end of the second spacer member 18d. The length from the lower surface of the armor member 11a to the lower end of the first spacer member 17d is L1.

Guide holes (corresponding to the guide holes 23a to 23d in FIG. 7) corresponding to the first spacer members 17a to 17d are formed through the wiring board 20. When the wiring board 20 is fixed to the lower surface of the armor member 11a, end portions of the first spacer members 17a to 17d are inserted through the corresponding guide holes of the wiring board 20. For example, if the shape of the first spacer members 17a to 17d is cylindrical, then the diameter of the guide holes is the same as that of the first spacer members 17a to 17d.

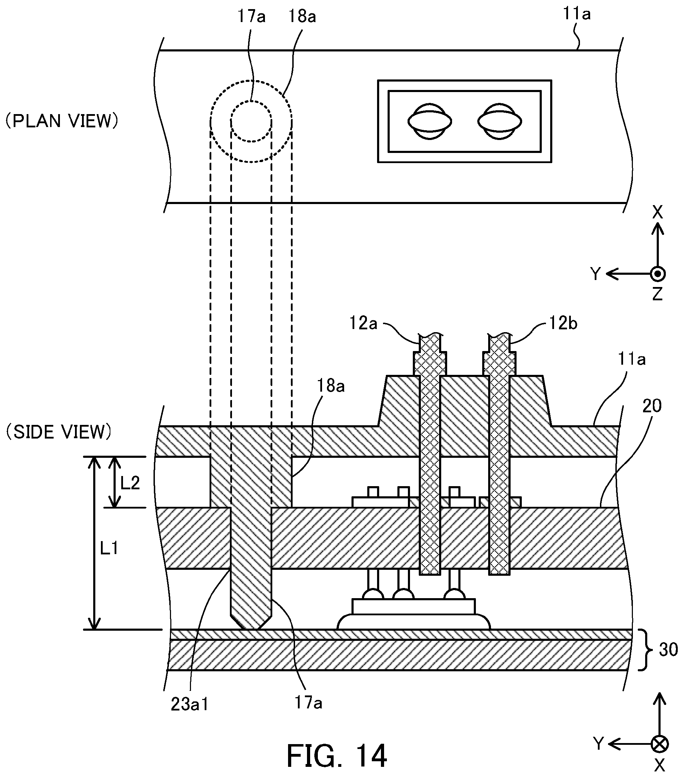

In FIGS. 13 and 14, the first spacer members 17a to 17d and the second spacer members 18a to 18d have a cylindrical shape. However, the first spacer members 17a to 17d and the second spacer members 18a to 18d may have, for example, a prismatic shape.

FIG. 14 is an enlarged plan view and an enlarged sectional view of a fixing region of spacer members. The plan view of FIG. 14 is an enlarged view of the region A2 of FIG. 13. The sectional view of FIG. 14 is a sectional view of a region of the plan view of FIG. 14 taken along the line I2-I2 of FIG. 13. However, in the sectional view of FIG. 14, the wiring board 20 and the circuit board 30 are fixed to the case 10 as in FIGS. 3 and 4.

As described above, the first spacer member 17a is a columnar member having the same central axis as that of the second spacer member 18a and having a cross-sectional area smaller than that of the second spacer member 18a, and is formed to protrude from the lower end of the second spacer member 18a. When the wiring board 20 is fixed to the lower surface of the armor member 11a of the case 10, the first spacer member 17a is inserted into the guide hole 23a1 of the wiring board 20. The first spacer member 17a passes through the guide hole 23a1, and the lower end of the second spacer member 18a comes into contact with the upper surface of the wiring board 20.

The lower end of the second spacer member 18a comes in contact in this way with the upper surface of the wiring board 20, so that the predetermined second distance L2 is maintained between the lower surface of the armor member 11a and the upper surface of the wiring board 20. Furthermore, because the first spacer member 17a is inserted through the guide hole 23a1, it is possible to accurately position the wiring board 20 in the horizontal direction with respect to the armor member 11a by a simple operation.

In addition, the circuit board 30 is fixed to the case 10 in a state in which the lower end of the first spacer member 17a is in contact with the upper surface of the circuit board 30. As a result, the distance between the lower surface of the armor member 11a and the upper surface of the circuit board 30 is maintained at the predetermined first distance L1. As a result, the distance between the lower surface of the wiring board 20 and the upper surface of the circuit board 30 is maintained at a desired distance.

The above description is merely indicative of the principles of the embodiments. A wide variety of modifications and changes may also be made by those skilled in the art. The embodiments are not limited to the precise configurations and example applications indicated and described above, and all appropriate modifications and equivalents are regarded as falling within the scope of the embodiments as defined by the appended patent claims and their equivalents.

### Reference Signs List

1 semiconductor device
10 case
10a housing member
10b, 10c terminal holding member
10d lid member
11a armor member
11a1,11a2 edge portion
11b side wall
11c, 11d opening
12a to 12j, 13a to 13d external connection terminal
12a1,12b1 end portion
13a1,13b1,13c1,13d1 flat plate portion
13a2,13b2,13c2,13d2 connection portion
14a to 14d, 17a to 17d first spacer member
15a to 15d, 18a to 18d second spacer member
16a, 16b gate port
20 wiring board
20a first edge portion
20b second edge portion
21a, 21b wiring pin
22a to 22j wiring hole
23a to 23d, 23a1 guide hole
24a to 24c circuit pattern
30 circuit board
31a1 to 31a4, 31b1 to 31b4, 31c1 to 31c4, 31d1 to 31d4, 31e semiconductor chip
32 insulating plate
33a to 33g circuit pattern
34a, 34b solder
40 sealing member
A1, A2 region
G1 to G4 gate terminal
L1 first distance
L2 second distance
Q1 to Q4 transistor
S1 to S4 auxiliary source terminal

## Claims

1. A semiconductor device, comprising:
a circuit board;
a wiring board opposed to an upper surface of the circuit board, arranged with a first gap with respect to the upper surface of the circuit board, and having a wiring hole and a guide hole penetrating therethrough;
a case including an armor member opposed to an upper surface of the wiring board and arranged with a second gap with respect to the upper surface of the wiring board, an external connection terminal fixed to the armor member and having a lower end inserted into the wiring hole of the wiring board to be electrically connected to the wiring hole, a first spacer member protruding from a lower surface of the armor member to be inserted through the guide hole of the wiring board and having a lower end touching the upper surface of the circuit board to maintain a first distance between the lower surface of the armor member and the upper surface of the circuit board, and a second spacer member protruding from the lower surface of the armor member and having a lower end touching the upper surface of the wiring board to maintain a second distance between the lower surface of the armor member and the upper surface of the wiring board;
a sealing member with which the first gap and the second gap are filled to seal the wiring board.

2. The semiconductor device according to claim 1, wherein the external connection terminal is press-fitted into the wiring hole of the wiring board.

3. The semiconductor device according to claim 1, wherein:
the armor member is formed in a plan view of the semiconductor device at least in a region above a first edge portion and a second edge portion of the wiring board which are opposed to each other; and
two or more sets of the first spacer member and the second spacer member are formed along the first edge portion in a region of the lower surface of the armor member opposed to the first edge portion, and one or more sets of the first spacer member and the second spacer member are formed along the second edge portion in a region of the lower surface of the armor member corresponding to the second edge portion.

4. The semiconductor device according to claim 1 further comprising a semiconductor chip arranged on the upper surface of the circuit board,
wherein:
the wiring board further includes a wiring pin protruding from a lower surface of the wiring board; and
an upper surface of the semiconductor chip and a lower end of the wiring pin are bonded to each other via a solder in the first gap.

5. The semiconductor device according to claim 1, wherein:
the armor member is formed at least in a region above a first edge portion of the wiring board in a plan view of the semiconductor device,
the case further includes a gate port formed in a side portion of the armor member, the sealing member being injected into the gate port; and
the first spacer member and the second spacer member are formed on the lower surface of the armor member at positions shifted from the gate port.

6. The semiconductor device according to claim 1, wherein a tip portion of the first spacer member, which comes into contact with the upper surface of the circuit board, has a cross-sectional area reduced in a tapered shape toward the upper surface of the circuit board.

7. The semiconductor device according to claim 1, wherein:
the second spacer member is formed in a columnar shape;
the first spacer member protrudes from a lower end of the second spacer member and has a columnar shape having a cross-sectional area smaller than a cross-sectional area of the second spacer member.

8. The semiconductor device according to claim 1 further comprising a semiconductor chip arranged on the upper surface of the circuit board for performing a switching operation,
wherein:
an upper end of the external connection terminal protrudes from an upper surface of the armor member; and
the upper end of the external connection terminal forms a control terminal for inputting a control signal for controlling the switching operation of the semiconductor chip.

9. The semiconductor device according to claim 1, wherein:
the armor member includes a first region and a second region formed above a first edge portion and a second edge portion, respectively, of the wiring board, the first edge portion and the second edge portion being opposed to each other in a plan view of the semiconductor device, and
an opening is formed between the first region and the second region of the armor member in the case, and
the case further includes a lid member blocking the opening.

10. A semiconductor device manufacturing method, comprising:
a preparation step for preparing a circuit board, a wiring board having a wiring hole and a guide hole penetrating therethrough, and a case including an armor member to which an external connection terminal having one end protruding from one main surface is fixed, a first spacer member protruding from the one main surface of the armor member, and a second spacer member protruding from the one main surface of the armor member and having a length from the one main surface shorter than a length of the first spacer member;
a first setting step for bringing the wiring board closer to the armor member from a side of the one main surface of the armor member in the case, inserting the first spacer member through the guide hole, inserting one end of the external connection terminal into the wiring hole to electrically connect the wiring hole and the external connection terminal, and bringing an end portion of the second spacer member into contact with the wiring board;
a second setting step for arranging the circuit board opposite the wiring board on a side of the wiring board opposite to the armor member and bringing the first spacer member inserted through the guide hole of the wiring board into contact with the circuit board; and
a sealing step for filling a first gap between the circuit board and the wiring board and a second gap between the wiring board and the armor member with a sealing member to seal the wiring board.

11. The semiconductor device manufacturing method according to claim 10, wherein in the first setting step, the first spacer member is inserted through the guide hole, one end of the external connection terminal is inserted into the wiring hole, and an end portion of the second spacer member is brought into contact with the wiring board to make the second spacer member support the wiring board, with respect to the case arranged with the one main surface of the armor member facing upward.

12. The semiconductor device manufacturing method according to claim 10, wherein in the first setting step, one end of the external connection terminal is press-fitted into the wiring hole.

13. The semiconductor device manufacturing method according to claim 10 further comprising, between the second setting step and the sealing step, a bonding step for bonding, via a solder in the first gap, a surface on a wiring board side of a semiconductor chip arranged on a main surface on the wiring board side of the circuit board and an end portion on a circuit board side of a wiring pin arranged on the wiring board so as to protrude toward the circuit board side.
